Europäisches Patentamt

European Patent Office

Office européen des brevets

(19)

(11) **EP 1 302 987 A1**

(12) ## EUROPEAN PATENT APPLICATION

(43) Date of publication:
**16.04.2003 Bulletin 2003/16**

(51) Int Cl.$^7$: **H01L 29/51**, H01L 29/423

(21) Application number: **01124658.4**

(22) Date of filing: **16.10.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **SILICONIX, INC.**
**Santa Clara, California 95054 (US)**

(72) Inventors:
• **Chang, Mike F.**
**Cupertino, CA 95104 (US)**

• **Lui, Sik K.**
**Sunnyvale, CA 94087 (US)**
• **Tai, Sung-Shan**
**San Jose, CA 95129 (US)**

(74) Representative: **Kolb, Georg**
**DaimlerChrysler AG,**
**Intellectual Property Management**
**IPM, C106**
**70546 Stuttgart (DE)**

(54) **Trench-gated vertical MOSFET having gate oxide layer containing cesium and process of forming the same**

(57)    Cesium isimplanted into the gate oxide layer of a vertical trench-gated MOSFET. The cesium, which is an electropositive material, reduces the threshold voltage of the device and lowers the on-resistance by improving the accumulation region adjacent the bottom of the trench.

**Fig. 4**

EP 1 302 987 A1

**Description**

FIELD OF THE INVENTION

This invention relates to metal-oxide-silicon field-effect transistors (MOSFETs) and in particular vertical MOSFETs in which the gate is formed in a trench.

BACKGROUND OF THE INVENTION

It is known to fabricate vertical MOSFETs in which the gate is formed in a trench. Such devices are sometimes referred to as TrenchFETs, UMOSFETs or trench-gated double-diffused MOSFETs (DMOSFETs). Trench-gated DMOSFETs are generally preferred to planar DMOSFETs because they can be formed with a higher cell packing density and therefore have a lower on-resistance.

There are, however, some disadvantages to trench-gated DMOSFETs. Having the gate positioned in a trench which extends downward into the drain tends to increase the capacitance between the gate and the drain for a given gate oxide thickness. This higher gate-to-drain capacitance reduces the switching speed of the device and this can be a problem in, for example, pulse width modulation applications. Second, when the device is required to block a reverse voltage, the electric field reaches a high level at the comers of the trench. This may create impact ionization and the consequent injection of hot carriers into the gate oxide. As a result, the gate oxide layer can be damaged leading to premature failure of the device.

These problems are becoming all the more significant because MOSFETs are being required to operate at lower and lower supply voltages. This requires that the MOSFETs turn on at lower threshold voltages. The threshold voltage is determined by the following equation:

$$V_T = V_{FB} + \frac{1}{C_{OX}}Q_B + \phi_S \qquad (1)$$

where $V_T$ is the threshold voltage, $V_{FB}$ is the flat band voltage, $C_{OX}$ is the gate-drain capacitance across the gate oxide, $Q_B$ is the bulk charge, and $\phi_S$ is the surface potential. $C_{OX}$ in turn can be expressed as:

$$C_{OX} = \frac{\varepsilon_{OX}}{t_{OX}} \qquad (2)$$

where $\varepsilon_{OX}$ represents the permittivity of the gate oxide and $t_{OX}$ represents the thickness of the gate oxide layer. Thus reducing $t_{OX}$ reduces $V_T$ but at the cost of increasing $C_{OX}$.

Attempts have been made to solve these problems by increasing the thickness of the gate oxide layer at the bottom of the trench. A thick bottom oxide, however, weakens the accumulation layer that forms along the trench wall and thereby increases the on-resistance of the MOSFET.

SUMMARY OF THE INVENTION

The threshold voltage of a vertical trench-gated MOSFET is lowered by implanting cesium into the gate oxide layer. The cesium implant produces a positive charge which reduces the flat band voltage ($V_{FB}$ in equation (1) above). This techique is particularly useful when used in MOSFETs that have a thicker bottom gate oxide. The cesium in the bottom oxide acts as a positive charge which improves the accumulation region and thereby lowers the on-resistance of the device.

BRIEF DESCRIPTION OF THE DRAWINGS

> **Fig. 1** shows a cross-sectional view of a conventional vertical trench-gated DMOSFET.

> **Figs. 2** and **3** show how the semiconductor material may be tilted when the cesium is implanted.

> **Fig. 4** shows a cross-sectional view of a vertical trench-gated DMOSFET with a thicker bottom gate oxide and having cesium implanted in the gate oxide.

DESCRIPTION OF THE INVENTION

As equation (1) above indicates, the threshold voltage varies directly with the flat band voltage. Thus, reducing the flat band voltage will reduce the threshold voltage. The flat band voltage is expressed by the following equation:

$$V_{FB} = \phi_{MS} - \frac{Q_{ss}}{C_{OX}} \qquad (3)$$

where $\phi_{MS}$ is the work function between the gate and the silicon and $Q_{SS}$ is the charge in the gate oxide.

The flat band voltage can thus be reduced by increasing the charge in the gate oxide.

In accordance with this invention, the charge in the gate oxide is increased by implanting cesium, which is the most electropositive element known, into the gate oxide.

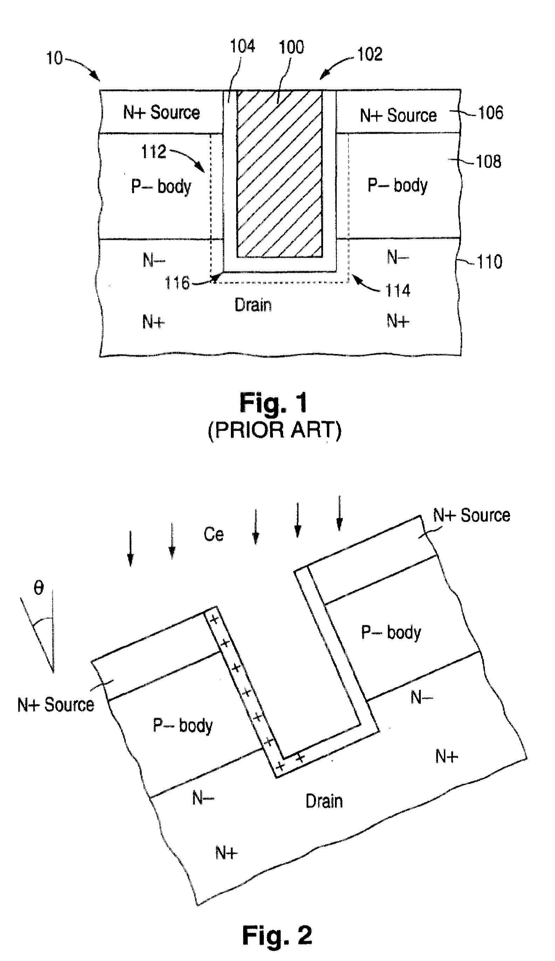

**Fig. 1** shows a cross-sectional view of a single segment of a trench-gated DMOSFET 10. A polysilicon gate 100 is formed in a trench 102 and is separated from the silicon by a gate oxide layer 104. As is well known, the trench is normally formed in a lattice of shapes--e. g., hexagonal, square or longitudinal "stripes"--which divide the MOSFET in a large number of cells, each capable of carrying a current. **Fig. 1** shows two cells, one to the right and one to the left of trench 102.

DMOSFET 10 includes an N+ source region 106, a P-body region 108, and an N drain region 110. The doping of drain region 110 can vary. Typically, as shown, drain region 110 is doped more lightly near the junction with the P-body to improve the device's ability to withstand a reverse voltage, but this invention is not limited to any particular drain doping pattern.

When DMOSFET 10 is turned on by increasing the voltage at the gate 100, a channel region 112 near the sidewalls of the trench 102 (indicated by the dashed lines) becomes inverted and permits a current to flow between the source region 106 and the drain region 110. Typically, the drain region 110 is biased positive with respect to the source region 106. Also, when the device is turned on, an accumulation region 114 (indicated by the dotted line) forms near the wall of the trench 102 in the drain region 110, and this reduces the resistance of the device in the on condition.

To reduce the threshold voltage (i.e., the voltage at which the device is turned on), the thicknesss of gate oxide layer 104 can be reduced (note that the drawings herein are not to scale). However, this risks damage to the gate oxide layer, particularly at the trench corners designated 116, where the strength of the electric field reaches a maximum. (See, e.g., U.S. Patent No. 5,072,266 to Bulucea et al., which is incorporated herein by reference).

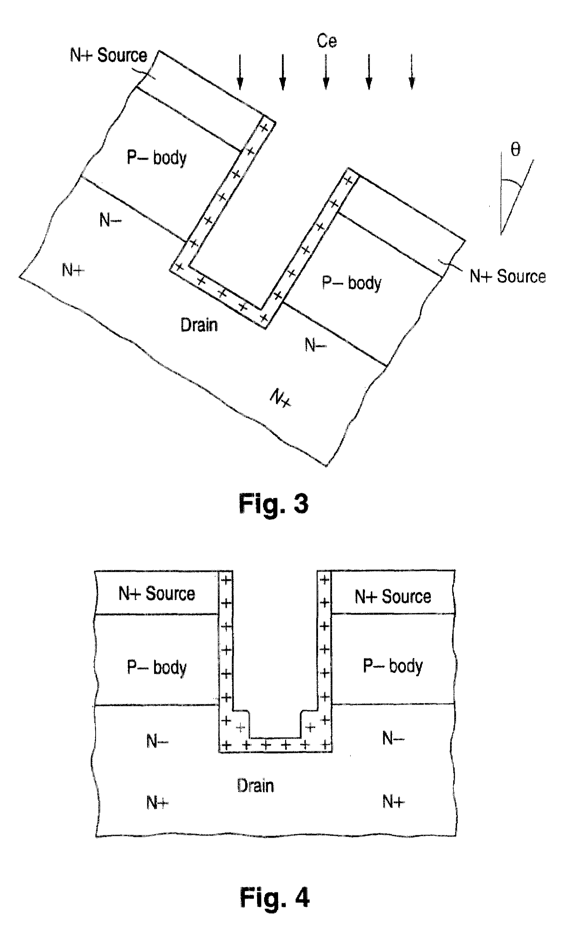

The threshold voltage of DMOSFET 10 can be reduced, without making the gate oxide layer 104 thinner, by implanting cesium into gate oxide layer 104. Preferably, this is done by inclining the die in which DMOSFET 10 is formed at an acute angle 0 with respect to direction of the implanted cesium atoms. The semiconductor die in which DMOSFET 10 is formed is rotated to four different positions about an axis parallel to the direction of implant, separated by 90°, two of which are shown in **Figs. 2** and **3**. By rotating the die to four different positions, the cesium atoms are implanted into the sidewalls of all segments of the trench, regardless of which lateral direction they run. The above-referenced U.S. Patent No. 5,072,266, for example, shows a hexagonal trench. If the trench is formed as a series of parallel longitudinal stripes, it may only be necessary to rotate the die to two positions, separated by 180°. In some embodiments, the die is not tilted at all and the cesium is implanted straight downward into the trench.

The angle θ can be in the range of 4 to 6 degrees. The cesium can be implanted, for example, at a dose of $5 \times 10^{10}$ to $5 \times 10^{13}$ $cm^{-2}$ and an energy of 30 to 120 keV, using a medium current implanter available from Varian Inc. This yields a concentration of cesium from $2 \times 10^{16}$ to $5 \times 10^{19}$ $cm^{-3}$ in the gate oxide.

The other steps of the process are well known to those of skill in the art and include: applying a trench mask having openings where the trench is to be formed; forming the trench by, for example, reactive ion etching (RIE) through the openings in the trench mask; forming and removing a sacrificial oxide layer along the walls of the trench to remove defects created by the etch; forming a gate oxide layer along the walls of the trench; introducing a gate material such as polysilicon into the trench; and forming source and body regions in the silicon or other semiconductor material by implanting negative and positive dopants, respectively.

The technique of this invention is particularly suitable for use with MOSFETs in which the gate oxide is thicker at the bottom of the trench, as shown in **Fig. 4**. The implantation of cesium helps to prevent the deterioration of the accumulation layer that often occurs in this type of MOSFET and thereby reduces the on-resistance of the device.

The foregoing embodiments are illustrative and not limiting. Many other variations and versions of this invention will be apparent to those of skill in the art.

## Claims

1. A method of forming a trench-gated MOSFET comprising:

    forming a trench in a semiconductor material;

    forming a gate oxide layer along as wall of the trench; and

    implanting cesium into the gate oxide layer.

2. The method of Claim 1 comprising introducing polysilicon into the trench.

3. The method of Claim 1 comprising forming source and body regions in the semiconductor material.

4. The method of Claim 1 wherein implanting cesium is performed with the semiconductor material tilted at an acute angle with respect to a direction of implanted cesium atoms.

5. The method of Claim 4 wherein implanting cesium is performed with the semiconductor material at four positions, the four positions being defined by rotating the semiconductor material about an axis parallel to a direction of implantation.

6. The method of Claim 5 wherein the four positions are separated by 90°.

7. A vertical trench-gated MOSFET comprising:

    a semiconductor material;

    a trench formed in the semiconductor material;

a gate oxide layer containing cesium; and

a gate material electrically insulated from the semiconductor material by the gate oxide layer.

8. The vertical trench-gated MOSFET of Claim 7 wherein the gate oxide layer is thicker adjacent a bottom of the trench than adjacent a channel region.

**Fig. 1**
(PRIOR ART)

**Fig. 2**

**Fig. 3**

**Fig. 4**

European Patent
Office

**EUROPEAN SEARCH REPORT**

Application Number

EP 01 12 4658

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (Int.Cl.7) |
| X<br>Y<br>A | US 6 078 090 A (GRABOWSKI WAYNE B  ET AL) 20 June 2000 (2000-06-20) <br>* column 15, line 29 - line 32 * | 1-3,7<br>8<br>4-6 | H01L29/51<br>H01L29/423 |
| X | US 5 929 690 A (WILLIAMS RICHARD K) 27 July 1999 (1999-07-27) <br>* column 6, line 34 - line 38 * | 1-3,7 | |
| Y | US 6 191 447 B1 (BALIGA BANTVAL JAYANT) 20 February 2001 (2001-02-20) <br>* figure 18 * | 8 | |
| A | US 6 291 298 B1 (GRABOWSKI WAYNE B  ET AL) 18 September 2001 (2001-09-18) <br>* figure 38 * | 8 | |
| A | EP 0 893 830 A (HITACHI LTD ;KANSAI ELECTRIC POWER CO (JP)) 27 January 1999 (1999-01-27) <br>* figure 10 * | 8 | TECHNICAL FIELDS SEARCHED (Int.Cl.7)<br><br>H01L |

The present search report has been drawn up for all claims

| Place of search | Date of completion of the search | Examiner |
|---|---|---|
| BERLIN | 26 March 2002 | Juhl, A |

**ANNEX TO THE EUROPEAN SEARCH REPORT
ON EUROPEAN PATENT APPLICATION NO.**                    EP 01 12 4658

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2002

| Patent document cited in search report | | Publication date | Patent family member(s) | | Publication date |
|---|---|---|---|---|---|
| US 6078090 | A | 20-06-2000 | US | 6049108 A | 11-04-2000 |
| US 5929690 | A | 27-07-1999 | US | 5744994 A | 28-04-1998 |
| | | | AU | 2931297 A | 05-12-1997 |
| | | | EP | 0898808 A1 | 03-03-1999 |
| | | | JP | 2000512805 T | 26-09-2000 |
| | | | WO | 9743823 A1 | 20-11-1997 |
| US 6191447 | B1 | 20-02-2001 | AU | 5173000 A | 18-12-2000 |
| | | | WO | 0074146 A1 | 07-12-2000 |
| | | | US | 2001000033 A1 | 15-03-2001 |
| US 6291298 | B1 | 18-09-2001 | AU | 5044600 A | 12-12-2000 |
| | | | EP | 1186019 A1 | 13-03-2002 |
| | | | WO | 0072372 A1 | 30-11-2000 |
| | | | US | 2001026961 A1 | 04-10-2001 |
| EP 0893830 | A | 27-01-1999 | JP | 10098188 A | 14-04-1998 |
| | | | EP | 0893830 A1 | 27-01-1999 |
| | | | US | 6342709 B1 | 29-01-2002 |
| | | | WO | 9826458 A1 | 18-06-1998 |